(19) Europäisches Patentamt
European Patent Office
Office européen des brevets

(11) Publication number: **0 421 512 A1**

(12) **EUROPEAN PATENT APPLICATION**

(21) Application number: **90202504.8**

(51) Int. Cl.[5]: **C08F 2/50**, G03F 7/029

(22) Date of filing: **21.09.90**

(30) Priority: **03.10.89 IT 2191489**

(43) Date of publication of application:
**10.04.91 Bulletin 91/15**

(84) Designated Contracting States:
**AT BE CH DE DK ES FR GB GR IT LI NL SE**

(71) Applicant: **CHIMIA PRODOTTI E PROCESSI SRL**
**Via G. Keplero, 10**
**I-20124 Milano(IT)**

(72) Inventor: **Bellobono, Ignazio Renato**
**Via G. Keplero, 10**
**I-20124 Milano(IT)**

(74) Representative: **de Pasquale, Carlo**
**Via Carlo Ravizza 53**
**I-20149 Milano(IT)**

(54) **Sensitisation and stabilisation of organometallic compounds acting as photocatalysts and photosensitisers in photochemical radical polymerisation process.**

(57) Object of the present invention is a radical polymerisation process of compounds containing carbon-carbon double bonds, carried out either photochemically, by means of visible or ultraviolet radiation, or by electron beams, employing at least one organometallic compound in which coordinated central atom is a transition element and ligands are coordinated to central atom by means of at least one element including C,N,P,As,Sb,O,S,Se,Te,B, and/or as elements in the form of the simple uninegative ions H,F,Cl,Br,I, and also employing preferably at least one photosensitizer of some type already known.

Object of the present invention is also a chemical stabilisation process for photocatalytic systems above, and particularly for those containing central ion in a high oxidation or relatively unstable state. This process is based on a suitable preparative method of the photocatalytic system, and/or on the addition of small amounts of compounds (mostly Lewis acids or bases), able to impart to the resulting composition a sufficiently lasting stability and efficiency, to the purpose of the present patent.



Xerox Copy Centre

## SENSITISATION AND STABILISATION OF ORGANOMETALLIC COMPOUNDS ACTING AS PHOTOCATALYSTS AND PHOTOSENSITISERS IN PHOTOCHEMICAL RADICAL POLYMERISATION PROCESS.

Qualities and properties of composite materials prepared from polymers and reinforcing fillers for a variety of applications are well known and exploited. Of particular relevance is industrial use of polyesters reinforced with glass or carbon fibres as well as of epoxy acrylic resins reinforced with similar filling materials.

Classical polymerisation procedures usually employ peroxide "catalysts" and "accelerators" (usually Co (II)-salts) to produce thermally, by oxidation-reduction, radicals necessary to initiate polymerisation. Drawbacks of this classic, but old, technology are chiefly lengthy polymerisation which requires enormous ovens with long residence times, release of remarkable amounts of toxic monomers (e.g. styrene) in the environment during the early periods of gelification and polymerisation, remarkable energy need, relatively remarkable need of labour.

It is well known, otherwise, in technical and patent literature, that photochemical irradiation can be used to initiate the rapid polymerisation of monomers and oligomers to a solid polymer.

Ultraviolet radiation is usually used for that purpose and requires suitable photoinitiators. This technology, together with electron beam, is widespread, e.g. in off-set printing, and in the manufacture of adhesives and coatings, even if thick and highly pigmented coatings still present some unsolved problems during photochemical polymerisation.

Main advantages of photochemical technology are, besides the short curing times (a few tens of seconds allow to obtain polymerisation of thin layers), overall energy saving (about 50%), complete automation, and strong reduction of pollution (which is practically eliminated). Such radiation-based techniques and the numerous monomers and oligomers, as well as the photoinitiator and radiation sources, are well and widely described in existing literature, as exemplified by the following:

"UV curing: science and technology", S.P. Pappas ed.; Technol. Mark. Corp. (1978).

Polymer News, vol.4, pp. 175,239,268 (1978); Vol. 6, p. 265 (1980).

For the manufacture of polymer composites containing reinforcing fillers, the use of photochemical polymerisation processes, on the contrary, has not met industrial favour, both because most commercial photoinitiators are partially ineffective, as absorption by polymeric materials at wavelengths less than 300-350 nm decreases dramatically efficiency of radical production (prohibitively high concentrations of photoinitiating species would be necessary, since radiation is also absorbed by "molds" which are mostly opaque to ultraviolet wavelengths), and because the reinforcing fillers themselves, especially in the case of carbon fibers, strongly interphere with all common commercial photoinitiators, given the required thickness, much higher than that of ordinary coatings.

It has now been found and this is the object of the present invention that difficulties and drawbacks of known techniques, may be fully obviated if a photochemical process is used, or in some way a process making use of radiant energy, in the presence of a system above to photoinitiate efficiently in the near ultraviolet (300-400 nm) where all polymers are transparent to radiations, or directly in the visible and in the infrared adjacent to the visible.

The choice of this system plays a primary role in relation to the chemical nature of the material to be polymerised. This choice has to be made case by case, in order to obtain optimal results, by this procedure, both qualitatively and quantitatively. As to quantities, generally minimum concentration levels of 0.01-0.5% by weight are necessary for the most active photoinitiating systems. Consequently, the choice of emission spectrum of radiation source is also important. It is possible by this way to make use of suitable lamps which do not emit in the far ultraviolet and are thus less harmful in respect to damages towards eyes and skin and towards environment (ozone generation).

By the procedure which is described in the present invention, the photoinitiating system is formed by a suitable combination of a photocatalyst, which is active in the near ultraviolet, in the visible and adjacent infrared portion of the spectrum and a photosensitizer, which is able to increase efficiency of photocatalyst in ultraviolet, visible, and infrared portions of the spectrum. It is thus possible, by starting from commercial monomers or prepolymers, if photoreactivity is provided, to obtain composites (e.g. glass - reinforced polymers, carbon fibre -reinforced or glass fibre-reinforced polyesters or epoxyacrylates, aluminium oxide reinforced polymers or even pigmented polymers, and so on) with remarkable thickness, up to some cm, and in any case no less than 2-3 mm, in remarkable short times (6-30 seconds) and with great economic advantages.

This process is suitable of manufacturing composites by lamination and pultrusion, even with complicated shapes.

For the latter purpose, photochemical gelification may be first achieved by using low power radiation sources, followed by shaping and final curing with normal power radiation sources.

The technique of "gel coating" may also be used by this procedure, consisting in coating two different materials (which may be separately manufactured by the process of the present invention) with thin resin layers, which are gelified photocatalytically following the process of the present invention and finally sticked together and polymerised thermally, or photocatalytically if radiation may penetrate after assembling the parts. Alternatively, the "gel coat" may be used as a finishing layer, if it contains resins able to impart any desired chemical, technical, or optical property.

Photocatalysts, following the present invention, are generally suitable organometallic derivatives of transition elements in which both coordinated central atom and organic ligand or ligands are chosen in merit of their photochemical and photocatalytic properties.

Sensitisation and photoactivation of organometallic compound may be obtained by multiple coordinate of at least a part of the molecule with various ligands, one of which must have suitable photochemical characteristics, with particular reference to oxidation number of central ion.

Ligands are characterized by the fact that they contain molecules or ions which coordinate to the central metal ion by one or more of the following elements they contain: C, N, P, As, Sb, O, S, Se, Te, B, and/or as elements in the form of simple uninegative ions: H, F, Cl, Br.

Some typical ligands are listed in the following, as non limitative examples, grouped following donor atoms (in all following formulus R may denote H, or an organic group, whether alkylic, arylic, or heterocyclic, also substituted):

CO, $CN^-$, RCOOH, RCHO, RCN, RNC (isonitrile);

$NH_3$, $C_5H_5N$, $NO_2^-$, $RNH_2$, $H_2NCH_2CH_2NH_2$, $H_2NCHR\text{-}RCHNH_2$,

$H_2N\text{-}(CHR')_n\text{-}(CHR)_mNH_2$, with n, m integers, and R′ alkyl or aryl different from R

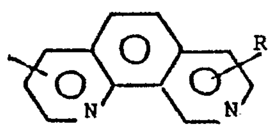 . 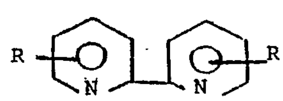 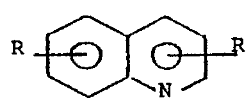 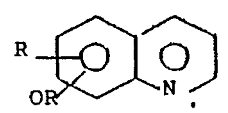

(also iso-)

$R_3P$, $PX_3$ (X = F, Cl, Br)

$R_3As$,

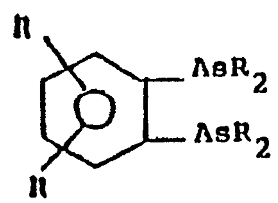

$H_2O$, $OH^-$, $O_2^-$, $CO_3^{2-}$, $SO_4^{2-}$, $S_2O_3^{2-}$, $SO_3^{2-}$, $RCOO^-$, ROH, $RO^-$,

$C_2O_4^{2-}$, $ONO^-$, $RCH_2COCH_2R$, RCOCOR, $RCH_2CO(CH_2)_n$ $COCH_2R$ $R_2S$, $SCN^-$, RSCN $RCONR_2$, RCH = NR, $RCH = N(CH_2)_n\text{-}N = CHR$ where n = O or an integer

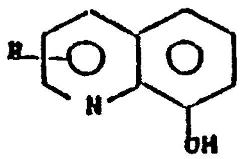 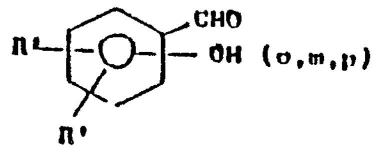 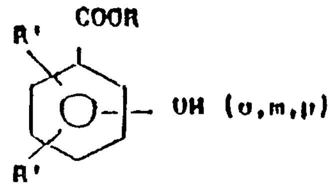

(R'=H, alkyl, alkoxy)

$H_2NCH_2COO^-$, and more generally aminocarboxylic acids, ethylenediamino tetraacetic acid, nitrilotriacetic acid, the simultaneous presence of $NH_2$ and COOH, or CN and COOH functions resulting of particular interest.

Central ions have a greater photocatalytic activity when they contain one, two or three d electrons in (n -1)d orbitals, where n is the principal quantum number (transition elements). These latter are consequently more interesting for practical applications.

Amount the most significative, even if nonlimitative, examples: Mn, Fe, Co, Ni, Cu, Mo, W, V, Pb, Zn, Zr, Pd, Ag, Au, Hg, Pt, Cr, Sn, U, Ge, lanthanides (Ce particularly), actinides. Obviously, each oxidation state of metal ion has to be considered as a different acceptor, particularly regarding photocatalytic activity, with this invention in view.

Besides those indicated in the reported examples (see later on), a wide class of organometallic derivatives have been positively tested, among those indicated above, and found to exhibit greater or lesser photocatalytic activity.

Finally, photosensitizers, with the purpose of the present invention are "coinitiators" or "activators", in other words molecules which, in the presence of the photocatalyst described above, are able to extend their action spectrum over a wider range of frequencies, which may be used practically, or to act as competitive ligands in respect to those which are present in the molecule of the organometallic derivative which works as photoinitiator/photocatalyst.

Nonlimitative examples of photosensitizers are: benzophenone, and its hydroxy, alkoxy, and alkyl derivatives (multifunctional too), acrylated benzophenone, diphenyl and acrylated diphenyl; compound of the following general formulas A), B), C) and D):

A)

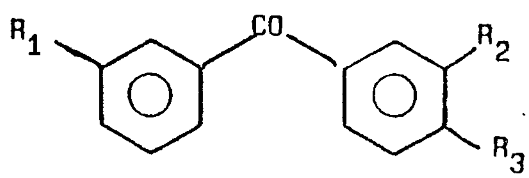

$R_1$, $R_2$, $R_3$ being H or alkyl groups or alkoxides, and including also a quaternary ammonium group able to impart solubility in water. Example:
3,3'-dimethyl, 4-methoxy-benzophenone, which is also a known photoinitiator

B)

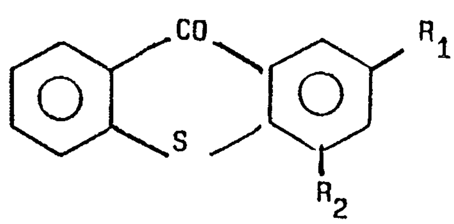

$R_1 = R_2 = CH_3$:2,4-dimethylthioxanthone; with $R_1 = Cl$ and $R_2 = H$, or with $R_1 = H$ and $R_2 = Cl$ : 2-chloro and 4'-chlorothioxanthone or their synergic mixtures;
$R_1 = R_2 = C_2H_5$: 2,4 diethylthioxanthone, with $R_1$ = isopropyl and $R_2$ = H:2-isopropylthioxanthone.

C)

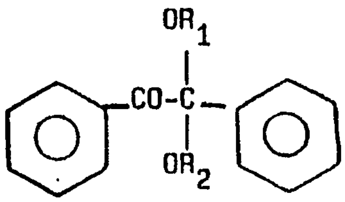

where $R_1$ and $R_2$, equal or different, are alkyl groups with number of carbon atoms ranging from 1 to 6 (one of them could also be H). Derivatives of classes B and C) are also known as classic photoinitiators when they are in the absence of an organometallic photocatalyst, and as such they are only partially "active" during the composite material photopolymerisation, relatively high concentrations of them being needed, as indicated in the Background Art above.

On the contrary, when photocatalysts are added, the whole system result photosensitized and these species are able to act even at modest or low concentrations, which alone would be insufficient to photoinitiate polymerisation in the operative conditions of technology described in the present invention.

D)

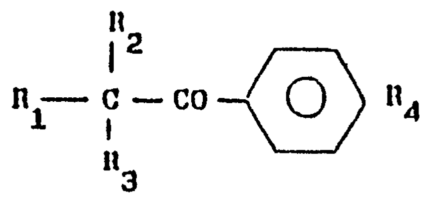

with $R_1$ = alkyl,aryl,H; $R_2$ = alkyl,aryl,H; $R_3$ = H,OH,OR′,R′ being alkyl,aryl,OH, or $R_3$ = alkyl,aryl,COR′,R′ being alkyl,aryl,OH; and $R_4$ = alkyl,aryl,H.

For class D) analogous observations as for preceding classes can be made.

Some nonlimitative examples of class D)

$R_1$ = phenyl;$R_2$ = H;$R_3$ = OR′(R′ = n or iso-butyl, or synergic mixture).

$R_1 = R_2 = R_3 = R_4 = H$

$R_1$ = H;$R_2 = R_3 = OC_2H_5$;$R_4$ = H

$R_1 = R_2 = CH_3$;$R_3$ = OH;$R_4$ = H

$R_1 = R_2 = CH_3$;$R_3$ = OH;$R_4$ = iso-propyl.

Besides those cited in the examples which follow, a wide class of derivatives which transfer excited state energy have been positively tested, among those generally listed above. Moreover, all types of commercial photoinitiators, which are not active as such, with the purpose of the present invention, are virtually useful as photosensitizing system together with organometallic derivatives, suitably chosen among those cited above. Otherwise, photocatalysts, when they contain as ligands photoactivating groups or moieties, may result active enough to work without any other photosensitizing component in combination with them.

One should consider that some of the photocatalytic systems, and particularly those containing, as central ions, elements with a high oxidation number or with a relatively unstable oxidation number, may show a certain unstability, owing to internal oxidation-reduction, as a consequence of which the system may become uneffective in a short time.

It has now been found, and this is an integral object of the present invention, that by suitable modification of the preparation method of organometallic complexes, such as described in the literature, the complex may be produced in a stable form, able to be employed with full efficience and for a satisfactorily long period of time, during photopolymerisation processes. Some examples, which will be reported later on, will clarify methodologies used to this purpose. These methodologies may imply modification of the known preparative procedure of the starting compound, or/and addition of an appropriate stabiliser of organometallic complex, mostly in the form of a Lewis acid or base, possessing suitable characteristics of a ligand, usually in relatively small amounts (0.05 - 10%) respect to other ligands present in the molecule of organometallic compound itself. Discussion of a specific case will help to understand the outlining principles.

Alkyl orthovanadates, such as triethyl vanadate for example, constitute one interesting group of

vanadium (V) derivatives, known in the literature, since the end of the last century, the preparation of which may be carried out following various methods (cf. F. Cartan, C. Caughlan, J. Phys.Chem., 64, 1756 (1960). Efficiency of these compounds, to the purpose of the present patent, is not stable with time unless the preparative method is modified, and the final product is partially constituted by a mixed complex (complex with mixed ligands).

Radiation Sources

Besides UV, visible and infrared radiation sources, e.g. from high or medium pressure mercury arc lamps, laser radiation may also be used. Electron beam curing may also operate more efficiently in the presence of the photocatalytic system described in the present invention, even if at much lower concentration than that needed for ultraviolet curing.

Photoreactive monomers and prepolymers which may be polymerized following the process of the present invention.

Wide classes of commercial products are available for this purpose, within the many industrial applications to which they are suitable (coating, inks, and so on). For some of them, however, as for allylic monomers (example in the following) the novelty of their photochemical polymerisation by the process described, deserves to be underlined.

Other diallyl monomers (e.g. diallylphthalate) have been positively tested in view of the present invention. Vinyl monomers and prepolymers, too, water soluble or not, have been positively tested.

For poly (vinyl alcohol), together with photocatalyst, photosensitizers able to impart water solubility are needed, such as 4-benzoyl, N, N, N-trimethyl benzenemethanamonium chloride

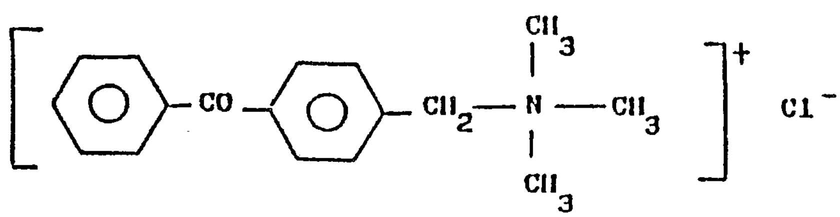

Also water soluble monomers or oligomers able to polymerise in aqueous emulsion may be employed, together with photoinitiators, such as the molecule above, containing quaternary ammonium functions, in the presence of photocatalysts.

Applications

Besides applications indicated in following examples and in the text, virtually any reinforcing filler, or any organic or inorganic pigment (up to 15-20 wt% or more) may be employed by using the process of the present invention.

When photoreactive dyes and/or pigments are incorporated (e.g. acrylated dyes) even greater amounts can be photocatalyzed without any difficulty.

As a particular case of application, methodology of the present invention may be used to improve photochemical production process of membranes described in Italian Patent No. 1.189.074, because this methodology allows to produce efficiently composite membranes which contain high amounts of selective transport agents, or sorbents of any kind (e.g. active carbons, specific reagents or sorbents), which highly absorb ultraviolet and/or visible radiation. The preparation of this kind of membranes is consequently possible only by the methods and technologies which are the object of the present invention.

Another important and potentially useful field is represented by protection of PVC tubes and articles against photodegradation. The manufacture of large plastic surfaces (ships, containers) should also receive substantial innovation by the process described (advantages; possibility of eliminating or reducing drastically polluting monomer emissions, such as those of styrene, possibility of substituting styrene with other less toxic and less volatile photoreactive monomers, as in example 7; possibility of local repairs by suitable

irradiation sources).

Also for applications of electronic industry (prepregs, multilayer manufacture) new prospects are afforded by this process.

From examples which follow and from what has been observed, the many advantages of the process described clearly stem out, particularly offering the possibility of employing wide classes of commercial monomers and prepolymers (other will be discovered and prepared for this purpose), with a great simplicity and rapidity of operations, with space and energy saving, with great practicalness and economy, from which a high level of industrial feasibility for this invention results.

Following examples are given only to illustrate and not to limitate some of the possible applications of the present invention.

## EXAMPLE 1

Glass fibre composite from glass fibre and styrenated polyester

67 g of styrenated polyester, suitable to be photopolymerized, owing to its composition and photochemical reactivity, by the photocatalytic process, and 33 g of glass fibre are assembled (1-2 mm thickness) sandwiched between mylar films. To the mixture 1% of a photocatalytic/photosensitizing system containing peroxobis (N,N′ ethylene bis (salicylideneiminate) dimethylformamide cobalt-III) and 1-2, diphenyl-2,2-dimethoxyethanone in a molar ratio ranging from 1:1 to 10:1, is previously added. Irradiation is carried out on a bench of 6 UV lamps (100 W/cm) at a speed of 4m/min (irradiation time about 15s). Polymerisation is complete in these conditions, as shown by physico-chemical investigations on the manufactured composite. If concentration of photocatalyst is increased to 7-8%, polymerisation is complete, in the conditions above, even reducing lamp power at 20-30% of maximum value.

By the same technique, pultrusion may also be carried out, provided irradiating lamps are housed conveniently around the sample.

Substantially similar results are obtained by using diphenyl as photosensitizer.

## EXAMPLE 2

Glass fibre composite from glass fibre and styrenated polyester

The same procedure as in Example 1 is followed, by employing N,N′-ethylene bis (salicylideneiminate) cobalt II together with peroxo-bis (N,N′-ethylene bis (salicylideneiminate) cobalt III) in a molar ratio of 2/1 as organometallic complex, biphenyl as sensitizer (same concentration as in Example 1), and by adding 0.1 - 0.8% cumene hydroperoxide.

Complete polymerisation times, which amount to 5-30 s, following concentration of additives and lamp power, are comparable to those of Example 1.

Similar results are obtained by using Co (III) complexes with ethylenediamine, EDTA, glycine, dimethylformamide, acetylacetone, and/or their combinations as ligands, with or without homologous Co (II) complexes, in this latter case by adding preferably small amounts of organic peroxides chosen in the wide class of commercially available products (ranging from benzoyl peroxide to acetylacetone peroxide, to methylethylketone peroxide), or of percarbonate (e.g. butyl or isopropyl percarbonates).

## EXAMPLE 3

Glass fibre composite from glass fibre and styrenated polyester

The same procedure as in Example 1, was followed 1-8% of triethylvanadate was employed as photocatalyst together with 0,1 -1% of 2-chlorothioxanthone as photosensitizer. The same results as in Example 1 were substantially obtained.

## EXAMPLE 4

Glass fibre composite from glass fibre and styrenated polyester

The same procedure as in example 3 was followed, but with oxo-di (8-quinolinoxo) vanadic (V) acid as photocatalyst, with substantially similar results.

EXAMPLE 5

Glass fibre composite from glass fibre and styrenated polyester

The same procedure as in Example 3 was followed, but with tris-(triphenylsilyl) vanadium (V) as photocatalyst, alone or with tetrakis (triphenyl silyloxy) vanadium (IV), with substantially similar results.

EXAMPLE 6

Polyacrylate/carbon fibre composites

67 g of a mixture of acrylic prepolymer (e.g. epoxyacrylate, or acrylated polyester, or acrylated polyurethane) and acrylic monomers (e.g. 1,6 hexanediol diacrylate, or diethyleneglycol diacrylate, or tetraethylene glycol diacrylate, alone or blended) and 33g of carbon fibre were assembled (1-3 mm thickness) sandwiched between mylar films. To the mixture 0,5-8% of oxo-di (8-quinolinoxo) vanadic (V) acid was previously added, together with 0.1-2% of a photosensitizer, such as: isopropylthioxanthone, or diethoxyacetophenone, or 2-butoxy, 1,2-diphenyl ethanone. The assembled sandwich was irradiated on a bench equipped with 8 UV lamps (100 W/cm) at a speed of 6-12 m/min, correspondent to an irradiation time of about 6-12 s. These curing times were enough for a satisfactory polymerisation. By this same technology pultrusion was carried out by means of high pressure arc lamps suitably oriented towards the running samples.

EXAMPLE 7

Glass fibre composites containing polyester poly (diethylene glycol carbonate bisallylether) as copolymer 70 g of a mixture containing styrene-free polyester, suitable to be polymerized photochemically and diethyleneglycol carbonate bis allyl ether as photoreactive diluent monomer, this latter with a weight ratio of 4:1 to 1:1 in respect to the former and 30g of glass fibre were assembled between glass plates, previously treated with a dewetting agent, were irradiated in the presence of 0.5-8% of oxo-di (8-quinolinoxo) vanadic (V) acid and 0.5-8% of 1,2-dephenyl-2,2-dimethoxyethanone, on a bench equipped with 14 UV lamps (100 W/cm) at a speed of 3 m/min.

After detachment from the glass plates, the irradiated specimen was conveniently polymerized, as shown by physico-chemical investigations.

EXAMPLE 8

Stabilisation of triethylvanadate to be used as photocatalyst

The same method described by W. Prandl and L. Hess (Z. anorg. Chem., 82, 103 (1913)) is followed to prepare the catalyst, with the difference that aminoethanol is added, together with ethanol, in a ratio of 1/20 respect to the latter.

When reaction is over, diethyl, aminoethyl vanadate is obtained together with triethylvanadate. Reaction products may be purified by distillation under high vacuum.

EXAMPLE 9

Stabilisation of s-butyl, i-propyl vanadate to be used as photocatalyst

The same procedure described by Cartan and Caughlan (loc. cit.) is followed, by employing ammonium vanadate as starting reagent, and using a 1/1 mixture of s-butanol and i-propanol as alkylating agents, instead of the single alkanols. To this mixture, however, 3-hydroxypropylamine is also added in a ratio varying between 1/10 and 1/1.

When reaction is completed, a mixed dialkyl, aminoalkyl vanadate is obtained, which may be purified, if necessary.

To the purpose of the present patent, anyway, raw reaction products and their mixtures are equally photoactive, provided they are conveniently stabilised.

It will be understood that while the invention has been described with respect to preferred examples and embodiments thereof, all with a nonlimitative nature, various changes and modifications and extension

of applications may be made, all within the full and intended scope of the claims which follow.

## Claims

1. Radical polymerisation process of compounds containing carbon-carbon double bonds, characterized in that it is carried out photochemically, by means of infrared, visible, and UV irradiation or by means of electron beams, by using a photocatalyst and/or a stabilised photocatalyst, and/or a sensitised photocatalyst including at least one organometallic compound in which the central coordinated atom is a transition element containing one, two or three d electrons in (n -1) d orbitals (n =principal quantum number) and in which ligands are coordinated to central atom by means of at least one of the following elements; C, N, P, As, Sb, O, S, Se, Te, B and or simple uninegative ions of elements H, F, Cl, Br, I, said photocatalyst being employed in an amount of at least 0.01 wt. % in respect to the unsaturated substance to be polymerized.

2. Process as set forth in Claim 1, characterized in that said composition contains also at least one photosensitizer of some known type.

3. Process as set forth in Claim 2, characterized in that said photosensitizer belongs to the following classes of compounds: biphenyl and its derivatives, benzophenone and its derivatives, alkyl and aryl phenones, thioxanthone and its derivatives, dialkyl and diarylacetones, as such or in the form of ketal derivatives.

4. Process as set forth in Claim 1, characterized in that the central coordinated atom of organometallic derivative belongs to at least one of the following elements: Mn, Fe, Co, Ni, Cu, Mo, W, V, Pb, Zn, Zr, Pd, Ag, Au, Hg, Pt, Cr, Sn, U, Ge, Ce.

5. Process as set forth in Claim 2, characterized in that the photosensitizer belongs to at least one of the following classes of compounds:

A)

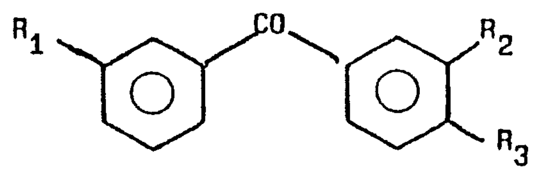

where $R_1$,$R_2$, $R_3$ are H, alkyls or alkoxides;

B)

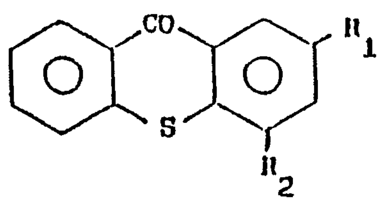

where $R_1$, and $R_2$, equal or different, are H or alkyls, or chlorine;

C)

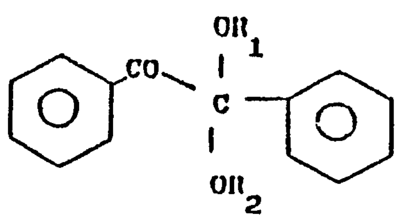

where $R_1$ and $R_2$, equal or different, are alkyls, one of them being possibly H;

D)

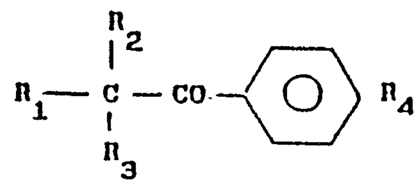

where $R_1$,$R_2$,$R_4$, equal or different, are alkyl or aryls or H, $R_3$ = H,OH,alkyl,aryl,OR′,-COR′ with R′ = alkyl,aryl,OH.

6. Process, as set forth in Claim 1, characterized in that said composition contains organic peroxy derivatives belonging to the class of peroxides, such as e.g. benzoyl peroxide, or acetylacetone peroxide, or methyl ethylketone peroxide, or to the class of hydroperoxides, such as e.g. cumene hydroperoxide, or to the class of peresters such as e.g. butyl or isopropyl percarbonate.

7. Process as set forth in claim 1, characterized in that the compound containing carbon-carbon double bonds belongs to the class of allylic monomers, such as e.g. particularly diethyleneglycol carbonate bisallyl ether, or diallyphthalate.

8. Stabilisation of organometallic compounds to be used for radical photopolymerisation processes, characterised by the fact that the photocatalyst molecule is constituted by a mixed complex, in which Lewis acids or bases are concomitantly used as ligands, even in every limited amounts (0.05 - 10% of stabilizing ligands respect to other ligands present in the complex), such as to impart to the mixture a sufficiently lasting stability and efficiency.

9. Stabilisation following claim 8, characterised by the fact that stabilising ligands are added in excess into the mixture respect to the composition containing these same ligands in the photocatalyst molecule.

10. Stabilisation following claim 8, characterised by the fact that stabilising ligands are added to a complex which does not contain these same ligands in its molecule.

European Patent Office

# EUROPEAN SEARCH REPORT

Application Number

EP 90 20 2504

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | WO-A-8 802 879 (LOCTITE CORP.)<br>* Examples 1-8 * | 1-4 | C 08 F 2/50<br>G 03 F 7/029 |
| X | EP-A-0 334 338 (DENTSPLY INTERNATIONAL, INC.)<br>* Whole document * | 1-3 | |
| X | EP-A-0 318 894 (CIBA-GEIGY AG)<br>* Claims 1,14; examples * | 1-2 | |
| X | EP-A-0 306 162 (MINNESOTA MINING AND MANUFACT. CO.)<br>* Claims; examples * | 1 | |

TECHNICAL FIELDS SEARCHED (Int. Cl.5)

C 08 F
G 03 F

The present search report has been drawn up for all claims

| Place of search | Date of completion of the search | Examiner |
|---|---|---|
| THE HAGUE | 22-01-1991 | GLIKMAN J-F.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)